# EUROPEAN PATENT APPLICATION

(11) **EP 1 453 202 A1**
(43) Date of publication of application: **01.09.2004**
(21) Application number: 04100507.5
(22) Date of filing: 11.02.2004
(51) Int. Cl.: H03K 5/12, H03K 5/06, H04L 25/03

(54) **Nyquist pulse driver for data transmission**

(30) Priority: 25.02.2003 US 374020
(71) Applicant: Sun Microsystems, Inc., Santa Clara, California 95054 (US)
(72) Inventor: Roy, Aninda K., Hilsboro, OR 97214 (US); Gauthier, Claude R., Cupertino, CA 95014 (US)
(74) Representative: Weihs, Bruno

(57) **Abstract**

A pulse driver circuit for data transmission uses multiple delay and driver stages to shape an input data pulse into a Nyquist -like data pulse. The delay stages each input the input data pulse, and then, dependent on the state of particular delay stages, output portions of the input data pulse, which are then driven by the driver stages so as to generate a data pulse having a shorter temporal width than the corresponding input data pulse.

## Description

### Background of Invention

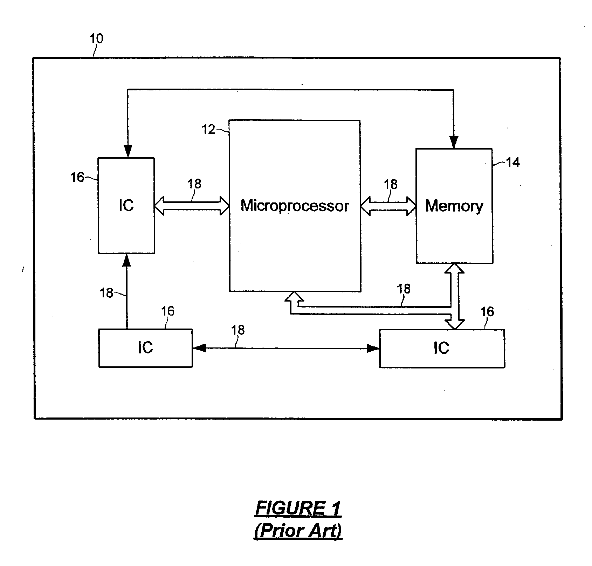

As shown in Figure 1, a typical computer system **10** has, among other components, a microprocessor **12**, one or more forms of memory **14**, integrated circuits **16** having specific functionalities, and peripheral computer resources (not shown), e.g., monitor, keyboard, software programs, etc. These components communicate with one another via communication paths **18**, e.g., wires, buses, etc., to accomplish the various tasks of the computer system **10**.

When an integrated circuit (**16** in Figure 1) communicates with another integrated circuit, i.e., "chip -to-chip communication," data is transmitted in a series of binary 0's and 1's from a transmitting circuit to a receiving circuit. Accordingly, at any particular time, a data signal received at the receiving circuit may have a low voltage potential representative of a binary '0' or a high voltage potential representative of a binary '1.'

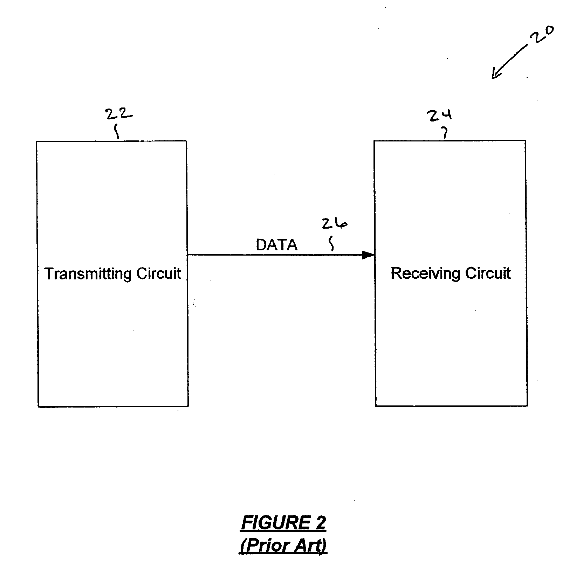

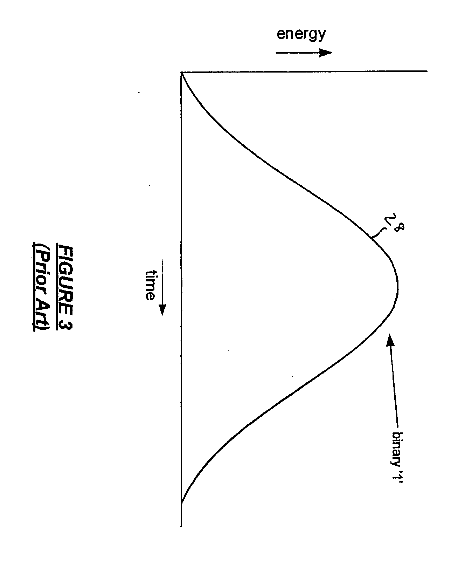

Figure 2 shows a typical transmission system **20**. The transmission system **20** includes in part a transmitting circuit **22** and a receiving circuit **24**. Data from the transmitting circuit **22** is transmitted, i.e., driven, to the receiving circuit **24** by means of a data signal (also referred to as "data channel") **26.** As discussed above, the transmitting circuit **22** communicates data by transmitting binary 0's and 1's to the receiving circuit **24.** Referring now also to Figure 3, in order to transmit a binary '1,' the transmitting circuit **(22** in Figure 2) generates a pulse **28** on the data signal **(26** in Figure 2). Thus, by generating pulses and not generating pulses on the data signal **26,** the transmitting circuit **22** communicates binary 0's and 1's to the receiving circuit **24**. In order to keep up with increasing clock speeds, data transmission frequency between circuits is often optimized to achieve the highest possible data rate, i.e., the speed at which data can be transferred between two components, for a given bandwidth and within power and error rate constraints.

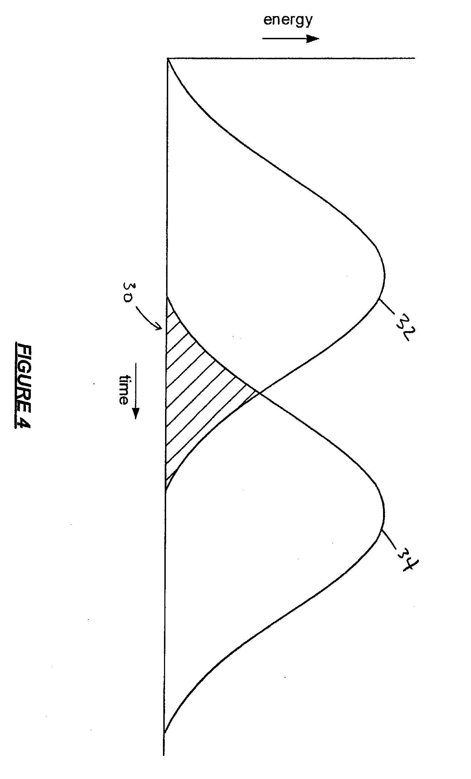

A significant factor in achieving the highest possible data rate relates to the signal to noise ratio present at the receiving circuit. The noise present at the receiving circuit includes noise introduced by the data channel **26** and noise attributable to interference from preceding bits of data. Such interference is known as 'intersymbol interference' (ISI). As shown in Figure 4, ISI **30** is a distortion in the received signal resulting from the temporal spreading and consequent overlap of individual pulses **32** and **34** to the degree that the receiving circuit cannot reliably distinguish between changes of state. It follows that at a certain threshold, intersymbol interference compromises the integrity of the data signal at the receiving circuit.

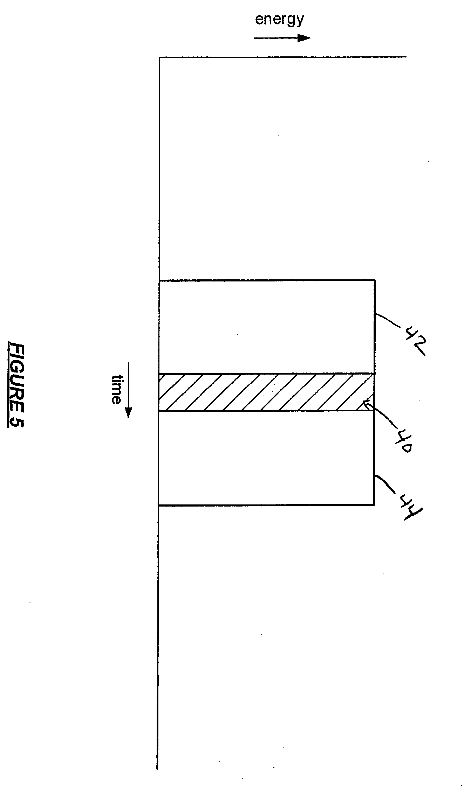

ISI becomes even more of a problem as data transmission frequency increases because data signal pulses get temporally positioned closer and closer together, thus increasing the chances of detrimental ISI. Traditional transmitting circuits transmitted a binary '1' as a step pulse, but, as shown in Figure 5, even more drastic effects of ISI **40** are likely in such an implementation due to the fact that if ISI **40** results, a much larger overlap of pulses **42** and **44** occurs.

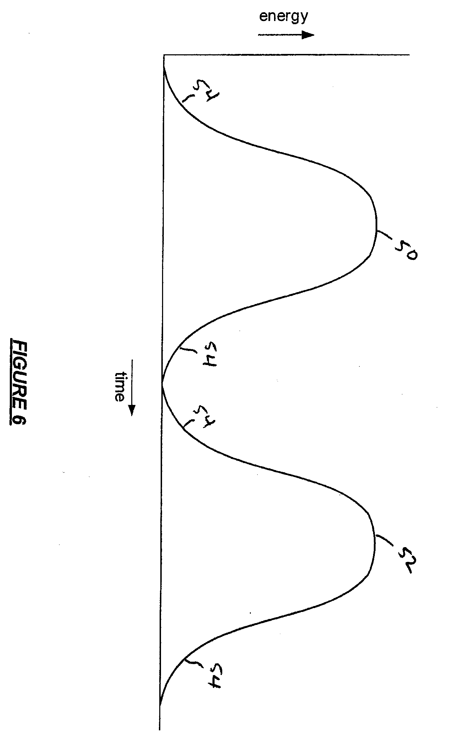

The benchmark pulse for low or no ISI in a transmission system is the theoretical pulse referred to in the art as the "Nyquist" pulse. A shown in Figure 6, ideal Nyquist pulses **50** and **52** have tails **54** that decay asymptotically so as to avoid the possibility of ISI. However, shaping a perfect Nyquist pulse in a transmission or communication system is often prohibitively difficult due to noise and other variations inherent in the transmission or communication system.

### Summary of Invention

According to one or more embodiments of the present invention, an apparatus comprise a pulse driver circuit arranged to transmit a modified data signal dependent on an input data signal to the pulse driver circuit, where the pulse driver circuit comprises: 1) a first branch comprising a first delay stage operatively connected to a first driver stage, where an input to the first delay stage is operatively connected to the input data signal, and where an output of the first driver stage is operatively connected to the modified data signal, and 2) a last branch comprising a last delay stage operatively connected to a last driver stage, where an input to the last delay stage is operatively connected to the input data signal, and where an output of the last driver stage is operatively connected to the modified data signal, where the first delay stage and the last delay stage are periodically activated so as to generate on the modified data signal a data pulse having a smaller temporal width than a corresponding data pulse on the input data signal.

According to one or more embodiments of the pres ent invention, a transmission system comprises: a transmitting circuit arranged to transmit a data signal pulse; a pulse driver circuit arranged to receive the data signal pulse and output a modified data signal pulse, where the pulse driver comprises 1) a first delay stage arranged to input the data signal pulse and operatively connected to a first driver stage arranged to output a first portion of the modified data signal pulse, and 2) another delay stage arranged to input the data signal pulse and operatively connected to another driver stage arranged to output another portion of the modified data signal pulse; and a receiving circuit arranged to receive the modified data signal pulse.

According to one or more embodiments of the present invention, a metho d for generating a data pulse on a data channel comprises inputting an input data pulse, delaying a first portion of the input data pulse by a first amount, driving the first portion onto the data channel, delaying another portion of the input data pulse by another amount, and driving the another portion onto the data channel.

According to one or more embodiments of the present invention, a communication system comprises: means for transmitting a data pulse; means for generating on a data signal a modified data pulse dependent on the data pulse, where the means for generating the modified data pulse comprises means for selectively delaying a portion of the data pulse to generate a delayed portion, means for driving the delayed portion onto the data signal, means for selectively delaying another portion of the data pulse to generate another delayed portion, and means for driving the another delayed portion onto the data signal; and means for receiving the data signal.

Other aspects and advantages of embodiments of the present invention will be apparent from the following description and the appended claims.

### Brief Description of Drawings

Figure 1 shows a typical computer system.

Figure 2 shows a typical transmission system.

Figure 3 shows a typical transmitted d ata signal pulse.

Figure 4 shows intersymbol interference (ISI) on a transmitted data signal.

Figure 5 shows intersymbol interference (ISI) on a transmitted data signal.

Figure 6 shows ideal Nyquist pulses.

Figure 7 shows a transmission system in accordanc e with an embodiment of the present invention.

Figure 8 shows a portion of the transmission system in accordance with an embodiment of the present invention.

Figure 9 shows a transmitted data signal in accordance with an embodiment of the present invention.

### Detailed Description

Embodiments of the present invention relate to a pulse driver design for a transmission system. Also, embodiments of the present invention relate to a Nyquist pulse driver that transmits data signal pulses so as to reduce intersymbo 1 interference (ISI) on a data signal. Additionally, embodiments of the present invention relate to a transmitting device that shapes a data signal pulse so as to reduce ISI on a data signal.

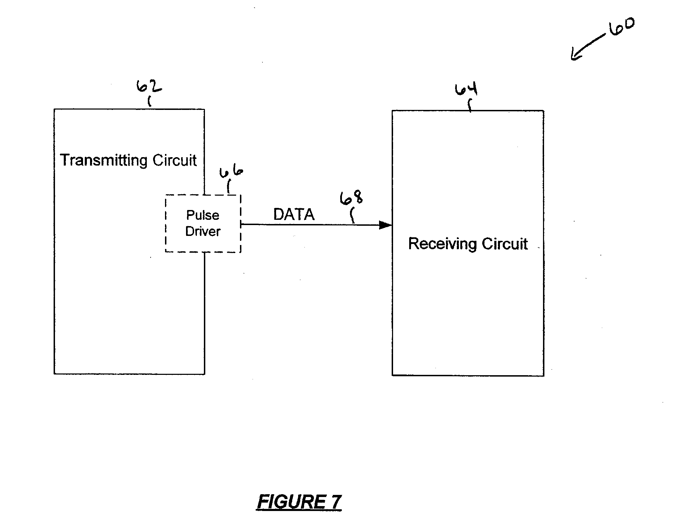

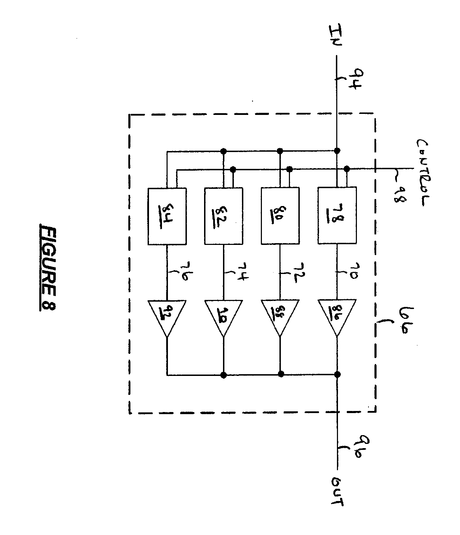

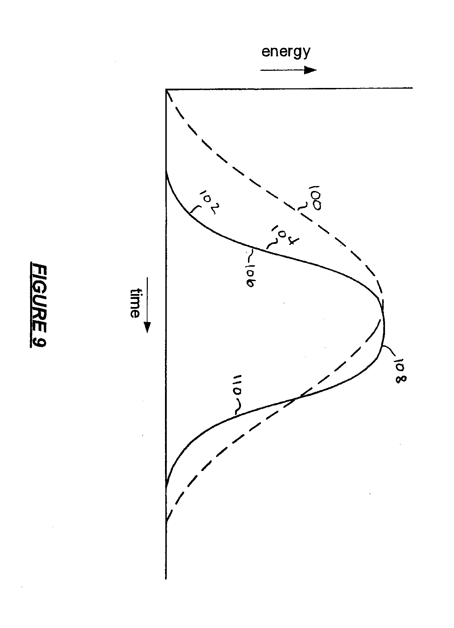

Figure 7 shows a transmission system **60** in accordance with an embodiment of the present invention. The transmission system **60** includes in part a transmitting circuit **62** and a receiving circuit **64**. Also shown in Figure 7 is a pulse driver circuit **66** that outputs data pulses to the receiving circuit **64** by means of a data signal (also referred to as "data channel") **68**. Those skilled in the art will understand that the pulse driver circuit **66** may or may not be part of the transmitting circuit **62.** Also, in those embodiments in which the driver circuit **66** is not part of the transmitting circuit **62**, the driver device **62** inputs data pulses from the transmitting circuit **62** and thereupon generates modified data pulses to the receiving circuit **64**. As will be described below with reference to Figures 8, 9, and 10, the pulse dr iver circuit **66** generates modified data pulses that result in reduced ISI on the data signal **68**.

Figure 8 shows an exemplary pulse driver circuit **66** in accordance with an embodiment of the present invention. The pulse driver circuit **66** includes a plurality of branches (or "legs") **70, 72, 74**, and **76** that each respectively include a delay stage **78, 80, 82,** and **84** and a driver stage **86, 88, 90,** and **92**. The inputs to the delay stages **78, 80, 82**, and **84** are each operatively connected to an input **94** to the pulse driver circuit **66**. The outputs of each of the delay stages **78, 80, 82**, and **84** are respectively operatively connected to the inputs of the driver stages **86, 88**, **90**, and **92**, which each have outputs operatively connected to an output **96** of the pulse driver circuit **66**.

The delay stages **78, 80, 82**, and **84** respectively present in each of the branches **70, 72, 74**, and **76** are controlled by a control signal **98** that is used to periodically activate and deactivate the branches **70, 72, 74,** and **76**. When the pulse driver circuit **66** is operating, i.e., when it is 'on,' the switching of the branches **70, 72, 74**, and **76** is staggered in time sequence by control of the delay stages **78, 80, 82**, and **84**. Those skilled in the art will understand that the control signal **98** may be analog or digital depending on the type(s) of delay stages being implemented in the pulse driver circuit **66**.

Those skilled in the art will understand that each of the branches **70, 72, 74**, and **76** in the pulse driver circuit **66** may be used to compensate for the variation of the impedance of the legs resulting from process, temperature, and/or voltage variations.

With reference now also to Figure 9, when the pulse driver circuit **66** inputs a data pulse, i.e., a binary '1,' from the transmitting circuit ( **62** in Figure 7), the first delay stage **78** is activated, i.e., switched 'on,' thereby delaying a portion of the input data pulse **100** by some amount. This delayed portion **102** of the input data pulse **100**, once outputted from the first delay stage **78** is driven to the output of the pulse driver circuit **66** by the first driver stage **86**. Then, the second delay stage **80** is activated, thereby delaying the next portion of the input data pulse **100** by some amount. This delayed portion **104** of the input data pulse **100**, once outputted from the second delay stage **80** is driven to the output of the pulse driver circuit **66** by the second driver stage **88**.

Because the first driver stage **86** is still outputting a portion **102** of the input data pulse **100,** the synthesis of the outputs from the first and second driver stages **86** and **88** results in this next outputted portion **104** of the input data pulse having an increased slope **106.** Thereafter, the third delay stage **82** is activated, thereby delaying a third portion of the input data pul se **100** by some amount. This delayed portion **108** of the input data pulse **100**, once outputted from the third delay stage **82** is driven to the output of the pulse driver circuit **66** by the third driver stage **90**. Thereafter, the last delay stage **84** is activated, thereby delaying a last portion of the input data pulse **100** by some amount. This delayed portion **110** of the input data pulse, once outputted from the last delay stage **84** is driven to the output of the pulse driver circuit **66** by the last driver stage **92**.

As shown in Figure 9, the input data pulse **100** is wider than a modified data pulse resulting from the shaping of portions **102, 104, 108**, and **110.** Accordingly, the pulse driver circuit **66** is capable of shaping a data pulse dependent on an input data pul se in order to reduce ISI present on a data signal or channel that propagates the shaped, or modified, data pulse.

Those skilled in the art will understand that, in one or more embodiments, the delay of each delay stage **78, 80, 82**, and **84** may be adjusted by a calibration system that operates at the start -up of the transmission system involving the pulse driver circuit **66**. During calibration, a training sequence may be run and the delays of the delay stages **78, 80, 82,** and **84** may be adjusted dependent on feedback from the calibration system. With proper calibration, the delay stages **78, 80, 82,** and **84** can be calibrated such that Nyquist-like data pulses may be produced for a particular data channel.

Advantages of the present invention may include one or mor e of the following. In one or more embodiments, because data pulses are shaped so as to reduce ISI on a data signal, higher data frequency transmission and/or reduced data transmission error rates may be achieved.

While the invention has been described wi th respect to a limited number of embodiments, those skilled in the art, having benefit of this disclosure, will appreciate that other embodiments can be devised which do not depart from the scope of the invention as disclosed herein. Accordingly, the sco pe of the invention should be limited only by the attached claims.

## Claims

1. An apparatus, comprising:
a pulse driver circuit arranged to transmit a modified data signal dependent on an input data signal to the pulse driver circuit, the pulse driver circuit comprising:
a first branch comprising a first delay stage operatively connected to a first driver stage, wherein an input to the first delay stage is operatively connected to the input data signal, and wherein an output of the first driver stage is operatively connected to the modified data signal, and
a last branch comprising a last delay stage operatively connected to a last driver stage, wherein an input to the last delay stage is operatively connected to the input data signal, and wherein an output of t he last driver stage is operatively connected to the modified data signal,
wherein the first delay stage and the last delay stage are periodically activated so as to generate on the modified data signal a data pulse having a smaller temporal width than a c orresponding data pulse on the input data signal.

2. The apparatus of claim 1, wherein the first delay stage and last delay stage are operatively controlled by a control signal.

3. The apparatus of claim 1, wherein the pulse driver circuit is calibrated at a sta rt-up phase of the apparatus.

4. A transmission system, comprising:
a transmitting circuit arranged to transmit a data signal pulse;
a pulse driver circuit arranged to receive the data signal pulse and output a modified data signal pulse, the pulse driver com prising:
a first delay stage arranged to input the data signal pulse and operatively connected to a first driver stage arranged to output a first portion of the modified data signal pulse, and
a second delay stage arranged to input the data signal pulse and operatively connected to a second driver stage arranged to output a second portion of the modified data signal pulse; and
a receiving circuit arranged to receive the modified data signal pulse.

5. The transmission system of claim 4, wherein the transmittin g circuit comprises the pulse driver circuit.

6. The transmission system of claim 4, wherein a control signal is arranged to temporally activate the first delay stage and the a second delay stage.

7. The transmission system of claim 4, wherein the pulse driver c ircuit is calibrated at a start-up phase of the transmission system,

8. The transmission system of claim 4, wherein the modified data signal pulse has a smaller temporal width than the data signal pulse.

9. A method for generating a data pulse on a data channel, comprising:
inputting an input data pulse;
delaying a first portion of the input data pulse by a first delay amount;
driving the first portion onto the data channel;
delaying a second portion of the input data pulse by a second delay amount;
and
driving the a second portion onto the data channel.

10. The method of claim 9, wherein a data pulse on the data channel corresponding to the input data pulse and comprising the first portion and the a second portion has a smaller temporal width than the input data puls e.

11. The method of claim 9, wherein the first delay amount and the a second delay amount are dependent on a control signal.

12. A communication system, comprising:
means for transmitting a data pulse;
means for generating on a data signal a modified data pulse d ependent on the data pulse, the means for generating the modified data pulse comprising:
means for selectively delaying a first portion of the data pulse to generate a first delayed portion,
means for driving the first delayed portion onto the data signal,
means for selectively delaying a second portion of the data pulse to generate a second delayed portion, and
means for driving the a second delayed portion onto the data signal; and
means for receiving the data signal.

13. The communication system of claim 12, wherein the modified data pulse comprises the first delayed portion and the a second delayed portion, and wherein the modified pulse has a smaller temporal width than the data pulse.
